# EUROPEAN PATENT APPLICATION

(11) **EP 4 550 822 A1**
(43) Date of publication of application: **07.05.2025**
(21) Application number: 23206864.3
(22) Date of filing: 30.10.2023
(51) Int. Cl.: H04N 25/773, G01T 1/24, H03K 3/03, H03K 3/033

(54) **PHOTON COUNTING IMAGE SENSOR**

(71) Applicant: Pi Imaging Technology SA, 1015 Lausanne (CH); Carl Zeiss Microscopy GmbH, 07745 Jena (DE)
(72) Inventor: CARIMATTO, Augusto, 1015 Lausanne (CH); ANTOLOVIC, Ivan Michel, 1015 Lausanne (CH)
(74) Representative: Ridderbusch, Oliver

(57) **Abstract**

An image sensor includes photon-counting detector elements (10) and a first group of pulse shapers (20) to convert signals (12) from the photon-counting detector elements (10) into pulse shaper output streams (22) in which pulses (23) have at minimum a first pulse length (t1). A connection unit (30) combines a plurality of the pulse shaper output streams (22) into at least one macropixel stream (32). The at least one macropixel stream (32) is processed by at least one monostable/astable circuit (40) which outputs a processed stream (42) in which pulses (43) have a second pulse length (t2). The second pulse length (t2) is shorter than the first pulse length (t1) by a time span t_PF and thus a pulse-free interval (PF) for at least the time span t_PF is created after each pulse (43) in the processed stream (42).

## Description

### FIELD OF THE DISCLOSURE

The present disclosure relates to an image sensor including photon-counting detector elements and a method for operating an image sensor.

### BACKGROUND OF THE DISCLOSURE

Image sensors with photon-counting detector elements such as Single-Photon Avalanche-Diodes (hereinafter SPADs) are, for example, described in WO 2020 / 151 838 A1 and WO 2020 1207 571 A1 as well as in the following prior art documents:
[1]: A. Carimatto et al., "Multipurpose, fully-integrated 128x128 event-driven MD-SiPM with 512 16-bit TDCs with 45 ps LSB and 20 ns gating in 40nm CMOS technology", IEEE SOLID-STATE CIRCUITS LETTERS, Vol. 1, No. 12, December 2018, doi: 10.1109/LSSC.2019.2911043.
[2]: L. H. C. Braga et al., "A Fully Digital 8x16 SiPM Array for PET Applications With Per-Pixel TDCs and Real-Time Energy Output," IEEE J. Solid-State Circuits, Vol. 49, no. 1, pp. 301-314, Jan. 2014, doi: 10.1109/JSSC.2013.2284351.
[3]: M.-J. Lee et al., "High-Performance Back-Illuminated Three-Dimensional Stacked Single-Photon Avalanche Diode Implemented in 45-nm CMOS Technology," IEEE J. Sel. Top. Quantum Electron., Vol. 24, no. 6, pp. 1-9, Nov. 2018, doi: 10.1109/JSTQE.2018.2827669.
[4]: S. Lindner, C. Zhang, I. M. Antolovic, M. Wolf, and E. Charbon, "A 252 × 144 SPAD Pixel Flash Lidar with 1728 Dual-Clock 48.8 PS TDCs, Integrated Histogramming and 14.9-to-1 Compression in 180NM CMOS Technology," in 2018 IEEE Symposium on VLSI Circuits, Jun. 2018, pp. 69-70, doi: 10.1109/VLSIC.2018.8502386.

Such image sensors comprise arrays of detector elements connected to electronics that measure and process the timing and intensity information of detected photons. The processed information is transmitted to an external system. Raw data is rarely sent as it would rapidly increase the requirements of the communication system to non-practical limits. With the fast advance of the technology, SPAD arrays have higher and higher numbers of SPADs and the interconnection between the SPADs and the electronics becomes harder to implement. In this context, it becomes unfeasible to provide electronic modules that serve individual SPADs. Architectures where pulses from multiple SPADs are combined into one single signal that is used as an input for the electronics are vastly common. SPADs whose outputs are combined are said to form a group or a macropixel which has the aggregated information of its individual SPADs. In this type of architecture, timing and intensity are preserved but the address or location of the SPAD within its group is usually lost. Many applications do not need to distinguish which of several SPADs in a macropixel generated the pulse. The electronics that serves a macropixel may include Time-to-Digital-Converters (TDC), counters, level comparators, triggers and scalers, among others. Regardless of the modules required by the application, glitches in the output line of the macropixel may cause instabilities in the module. Photons that trigger the SPADs arrive at the sensor randomly and asynchronously. The combination of the generated pulses, usually but not only performed with an OR connection, can create spurious pulses that are smaller in voltage or faster/shorter in time than expected pulses from the electronics. In systems where it is common to have banks of electronics that are swapped over time in double buffering fashion, it is also possible that spurious pulses appear if this switch coincides in time with the photon arrival. Those non-conforming pulses or glitches do not meet the input ratings of the following electronics and can cause it to fail with different degree of severity that could be unacceptable for the aimed field.

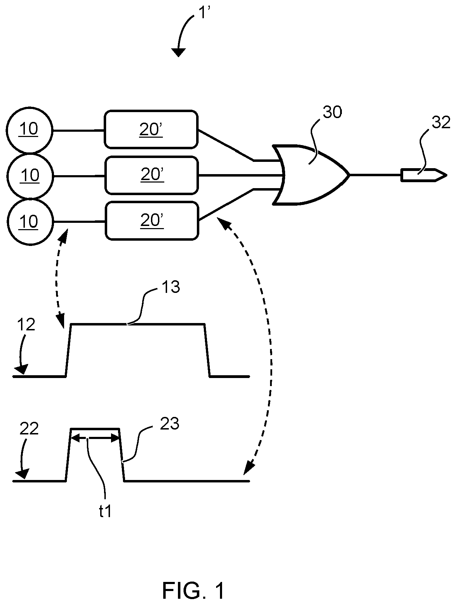

For easier understanding, reference is made to FIG. 1 which shows a related image sensor 1' comprising an array of photon-counting detector elements 10, namely SPADs. Signals 12 of the photon-counting detector elements 10 are processed by pulse shapers, namely monostables 20'. For consistency, the outputs of the pulse shapers / monostables will be referred to as pulse shaper output streams 22. A pulse 13 in one of the signals 12 represents a registered photon. The monostables 20' shorten the pulse length such that a pulse 23 in the pulse shaper output stream 22 has a first pulse length t1 which is shorter than the length of the original pulse 13.

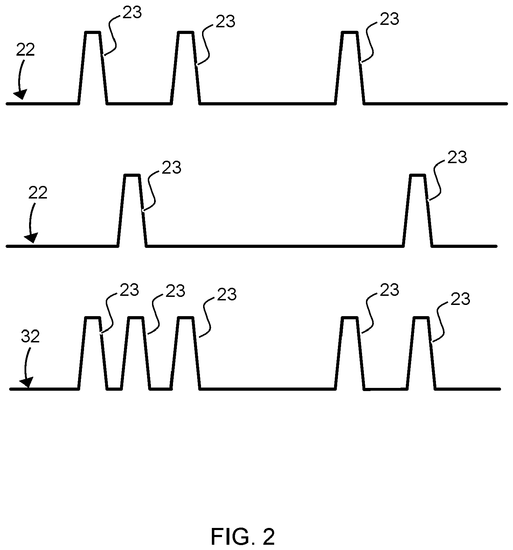

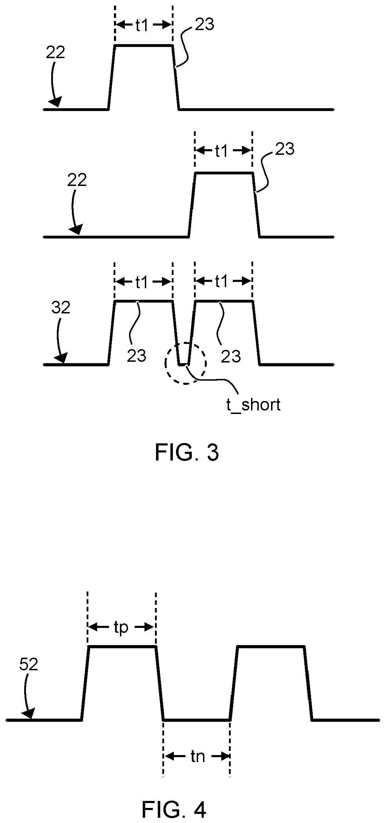

A connection unit 30 such as an OR element combines the pulse shaper output streams 22 which originate from the monostables 20' into a macropixel stream 32. This is shown in more detail in FIG. 2 which depicts two pulse shaper output streams 22 (stemming from two monostables 20' and thus from two photon-counting detector elements 10), wherein each pulse shaper output stream 22 includes several pulses 23 indicative of detected photons. The macropixel stream 32 includes all pulses 23 of the two pulse shaper output streams 22. FIG. 3 shows a similar case wherein, however, the pulses 23 originating from different SPADs are close to each other. In the macropixel stream 32, this has the consequence that a gap between the two pulses 23 has a short time period of t_short. The time period t_short can have any value as photons may hit the SPADs at any time. However, if t_short is too small, errors can occur in subsequent electronic modules: FIG. 4 shows rise and fall time requirements of electronic modules such as counters, TDCs or level detectors. A pulse of an input signal 52 for the electronic module must have a minimum length of tp, and a gap between pulses must have a minimum length of tn. The minimum length tn of a pulse-free interval is needed as a recovery time to set an internal state of the electronic module back to its original state so that it can correctly process a further pulse. Otherwise failures in the electronic module may occur or the electronic module may output erroneous results. The exact values of tp and tn depend on the specific electronic module. With reference to FIG. 3, it may be ensured that the pulses 23 always meet the requirement of tp as the pulse length t1 can be chosen by adequate design of the monostables 20' such that t1 ≥ tp is always met. However, the time span t_short of the gap between pulses 23 may have any value, and hence t_short may be shorter than the minimum required time span tn, potentially causing errors in the electronic module.

This is one example in which conventional image sensors generate glitches or pulses that do not meet the requirements of electronic modules and thus potentially cause errors in subsequent processing steps, for example metastability of the electronic module, wrong photon count values or a reduced signal-to-noise ratio. The invention addresses problems caused by irregular pulses and avoids malfunction of downstream electronics.

### SUMMARY OF THE DISCLOSURE

It is an **object** of the invention to provide an image sensor and a method which reduce or eliminate irregular pulses or glitches in an image sensor, in particular its macropixel output line, or in electronic modules connected to the macropixel output line.

The above-defined object is achieved with an image sensor and a method including the features of the respective independent claim.

An image sensor of an embodiment of the invention includes photon-counting detector elements and a first group of pulse shapers (e.g., monostables) arranged to convert signals from the photon-counting detector elements into pulse shaper output streams in which pulses have at minimum a first pulse length. The pulse shapers may be arranged in parallel to each other, i.e., each pulse shaper of the first group receives a signal from another of the photon-counting detector elements. The number of pulse shapers in the first group may match the number of photon-counting detector elements. Each output of one of the pulse shapers of the first group is referred to as a pulse shaper output stream. For each photon-counting detector element, a respective pulse shaper output stream may be generated. The image sensor further comprises a connection unit configured to combine a plurality of the pulse shaper output streams into at least one macropixel stream. The image sensor further comprises at least one monostable/astable circuit (i.e., at least one monostable circuit and/or at least one astable circuit) arranged to receive the at least one macropixel stream and to output a processed stream in which pulses have a second pulse length. The at least one monostable/astable circuit is configured such that the second pulse length is shorter than the first pulse length by a time span t_PF, to create a pulse-free interval for at least the time span t_PF after each pulse in the processed stream.

In an embodiment of a method for operating an image sensor of the invention, photons are received by photon-counting detector elements which output signals indicative of received photons. A first group of pulse shapers converts the signals from the photon-counting detector elements into pulse shaper output streams in which pulses have a first pulse length. A connection unit combines a plurality of the pulse shaper output streams into at least one macropixel stream. At least one monostable/astable circuit processes/receives the at least one macropixel stream and outputs a processed stream in which pulses have a second pulse length which is shorter than the first pulse length by a time span t_PF. This creates a pulse-free interval for at least the time span t_PF after each pulse in the processed stream.

The monostable/astable circuit ensures a defined minimum distance after each pulse to a next pulse. This allows to rule out that two pulses in the processed stream are too close to each other. The pulse-free interval is created by using a serial arrangement of in particular monostables, wherein the latter monostable (i.e., the monostable/astable circuit) has a shorter time period for returning to its stable state than the first monostable (i.e., the pulse shaper). The pulse-free interval of t_PF reduces the risk of errors in subsequent electronics which require a certain minimum pause between pulses. If t_PF is chosen in dependence of the required minimum pause, i.e., t_PF is at least as large as the required minimum pause, the risk can be fully ruled out that two consecutive pulses are too close to each other to be correctly processed. For clarity, it should be noted that the pulse-free interval is only created if the monostable/astable circuit is arranged downstream of the connection unit such that it receives the macropixel stream. In effect, the arrangement with the monostable/astable circuit leads to a deadtime in which no photon registration can be passed along, however, this deadtime avoids or reduces the risk of malfunction of further electronics that may process the processed stream.

### Optional embodiments

Advantageous variants of the image sensor of the invention and the method of the invention are the object of the dependent claims and are explained in greater detail in the following description.

### Electronic module and length of pulse-free intervals

The image sensor may include an electronic module to process a signal stream including the information from the photon-counting detector elements. The electronic module can be built on the same chip as the photon-counting detector elements.

In general, the electronic module may be any electronic device or circuit that performs intensity or time measurements on the received signals. The electronic module may consist of or include at least one of: a time-to-digital-converter (TDC), a digital counter, a level comparator, a trigger, a scaler, an inverter, a buffer, a pull-up, a latch, a level monostable, delay lines, a clock divider, a phase detector, a prescaler to reduce the frequency of an input signal for downstream components, or any other digital circuit. A TDC outputs digital data indicating, e.g., an arrival time of a detected photon. A digital counter outputs a count value indicating a number of detected photons. A level comparator may be configured to output data indicating whether or when a level in the received signal is above a certain threshold. A scaler may be configured to aggregate pulses in the received signals into a single output pulse; the single output pulse may in particular represent a predetermined number of input pulses. Other kinds of scalers may be configured to convert voltage levels of received signals to different voltage levels.

Whereas conventional image sensors may include an electronic module arranged such that it receives directly the combined output of the pulse shapers (here referred to as a macropixel stream), in various embodiments of the invention the electronic module is arranged to receive the processed stream, i.e., signals output by a monostable/astable circuit arranged downstream of the pulse shapers.

The electronic module may have a recovery time of tn, i.e., the electronic module requires a pause (pulse-free interval) with a length of at least tn between two pulses in the processed stream for distinguishing or correctly processing the pulses in the processed stream. A "required" pause may be understood such that pulses are incorrectly processed if tn is not met, or a risk of erroneous processing is above a predefined threshold if the pause is shorter than tn.

The at least one monostable/astable circuit may be configured such that t_PF is at least as long as tn, i.e., t_PF ≥ tn. In other words, the second pulse length t2 created by the at least one monostable/astable circuit is shorter than the first pulse length t1 of the pulse shapers by at least tn. In this case, it is always ensured that two pulses have a sufficient distance such that the recovery time of the electronic module is met.

Too avoid unnecessary long deadtimes, an upper limit of the minimal pulse-free interval t_PF can be defined. In particular, the first group of pulse shapers and the at least one monostable/astable circuit may be configured such that t_PF is smaller than two times tn (or three times tn).

The electronic module may also require that pulses in the processed stream have a minimum pulse length of tp. This requirement is met if the at least one monostable/astable circuit is configured such that the second pulse length t2 is at least as long as tp. Optionally, the first group of pulse shapers may be configured such that the first pulse length t1 is at least as long as tp+tn to allow sufficient long pulse-free intervals. Optionally, t1 is smaller than 2*(tp+tn) to avoid unnecessary long dead times.

If a processed stream is provided to electronic modules with different recovery times tn, then the longest tn should be chosen in the described embodiments. The image sensor may generate a plurality of processed streams which are input to different electronic modules (e.g., TDC and counters) which vary in their requirements for tp and tn. In this case, the monostable/astable circuits may differ from each other to generate different second pulse lengths t2, depending on the respective tp and tn of the following electronic module. All pulse shapers of the first group of one macropixel (i.e., pulse shapers connected to the same monostable/astable circuit) may cause pulses with the same pulse length t1; however, macropixels may differ in their respective t1, i.e., pulse shapers of the first group connected to one monostable/astable circuit may have another t1 than pulse shapers of the first group connected to another monostable/astable circuit. In this way, t1 and t2 may be chosen suitable for the respective requirements on tp and tn. Optionally, the pulse shapers of the first group and/or the monostable/astable circuits may be configured for flexible adjustment of their t1 and t2 during operation of the image sensor. In this case, the t1 and t2 values can be flexible adjusted in dependence on a current connection that is set with the connection unit, which adjustably generates and routes processed streams to different electronic modules. This allows to set t1 and t2 suitable for the respective tn and tp of each electronic module, considering a flexible momentary formation of macropixels.

### Pulse Shapers, e.g., Monostables, and Monostable/Astable Circuits

A pulse shaper may be understood as an electronic component which outputs a pulse for each received pulse, and wherein the output pulses have a length of at least t1. All output pulses may have the same length or may have differing lengths of equal or larger than t1. A pulse shaper may in particular be or include a monostable which may be understood as an electronic circuit or unit configured to receive an input signal and process the input signal to generate an output signal which changes between a stable state (no signal / no pulse) and an unstable state (a pulse when a photon is registered), and wherein the monostable has a defined time until its output changes from the unstable state to the stable state. The defined time leads to a defined pulse length. The photons registered with the detector elements thus lead to pulses with a common length defined by the monostables / pulse shapers. A monostable may also be referred to as a monostable circuit or monostable multivibrator.

The pulse shapers of the first group of pulse shapers may be, for example, level monostables which are triggered if a level of the signals from the photon-counting detector elements surpasses a predefined threshold. In principle, the pulse shapers may also be edge delayed monostables (edge detector monostables) which are triggered by an edge in the received signal, i.e., the beginning of a pulse representing the detection of a photon. Some or all of the pulse shapers may also be integrated with the respective photon-counting detector elements, i.e., a photon-counting detector element and a pulse shaper may form one integral unit.

Generally, a monostable/astable circuit can be understood as a monostable circuit or an astable circuit. An astable circuit is a circuit or electronic component generating an output that switches between at least two states and none of those states is permanently stable, however, it switches upon receipt of the first flank of a received pulse and switches back after a time shorter than t1 (or after a time of t2, wherein t2 may indicate a specific value or a span of values, all of which are shorter than t1). A plurality of monostable/astable circuits (each for processing one of the macropixel streams) may include different kinds of monostables or astables, or some monostables and some astables. A monostable/astable circuit may in particular be a level monostable or an edge delayed monostable (EDM). However, level monostables generally have a recovery time which is needed to reset their internal state after a pulse has been received. Level monostables thus require that a received first pulse and a second pulse are separated by a sufficiently long time, otherwise only the first pulse will be properly processed to have the desired pulse length (here: t2) whereas the second pulse will be incorrectly processed to have a pulse length shorter than t2. Such a short spurious pulse might cause errors in subsequent electronic modules. This problem is avoided if the at least one monostable/astable circuit is an EDM which is triggered by the edge of each new pulse and which outputs pulses of constant length even if a first pulse is followed by a second pulse without any pause in-between. Furthermore, the second pulse may also begin while the first pulse has not fully terminated, i.e., the rising edge of the second pulse may overlap with the falling edge of the first pulse, up to a certain degree. If the overlapping edges are still recognizable for the EDM, two pulses both with a length of t2 will be output. If the first and second pulses overlap strongly so that the rising edge of the second pulse cannot be identified by the EDM as a new pulse, the EDM will just output one pulse instead of two pulses, without any spurious pulses that may cause errors in subsequent electronics. This effect of suppression around half of the voltage of the power supply creates the effect of an extra dead-time, which can be as short as 200 ps.

### Connection unit

The connection unit is configured to combine a plurality of the asynchronous pulse shaper output streams (of the first group of pulse shapers) into at least one macropixel stream. A macropixel stream is thus the combination of two or more pulse shaper output streams and includes all pulses of those pulse shaper output streams. If one of those pulse shaper output streams includes a pulse at a specific time, the macropixel stream will also include a pulse at this specific time. If none of those pulse shaper output streams includes a pulse at a specific time, then also the macropixel stream will not include a pulse at this specific time. If pulses of different of the pulse shaper output streams timely overlap with each other, then the macropixel stream will include one pulse with a length defined by the overlapping pulses. The connection unit may be configured to output a plurality of macropixel streams which differ in their combination of pulse shaper output streams. As the connection unit combines outputs of several pixels (= photon-counting detector elements), the connection unit can be regarded as defining macropixels consisting of the photon-counting detector elements whose outputs are combined, and consequently the output of the connection unit is referred to as a macropixel stream.

The connection unit may be a connection matrix which is in particular configured to flexibly combine any of the pulse shaper output streams, creating re-configurable macropixels. The connection matrix may include an OR matrix in which a signal is output if anyone of several inputs of a logical OR unit receives a signal. The connection matrix may also include other logical units than OR connections to combine several inputs.

The connection matrix can be configured to flexibly change which outputs are combined at run-time, e.g., using an internal memory. Any arbitrary combination of outputs is possible, to which end the connection matrix may be equipped with SRAM memories and/or LUTs (LUTs: look-up tables). The connection matrix can be flexibly varied to change the number of macro-pixels. Furthermore the number of photon-counting detector elements to be combined into one macro-pixel can be flexibly set. The connection matrix can also bet set such that some of the pulse shaper output streams are just forwarded, without being combined with others of the pulse shaper output streams.

### Bank-switch assistance through artificial pulses (fake photons)

Errors can occur if a bank switch cuts a pulse in two, creating one or two spurious pulses that may cause errors in electronic components. This will be addressed in the following.

When an electronic component such as a counter gets enabled or disabled and receives a pulse at the same time, a spurious pulse can occur, thus leading the counter to a metastable state. To avoid metastability in the counters, pulses during a bank switch should be suppressed / rejected. This is achieved by introducing a signal emulating a photon ("fake-photon") before the switch for a period long enough until the switch has finished. Such a technique can be accompanied by an anti-glitch circuit as described, to avoid that glitches are created if the fake-photon signal is unlikely overlapped in time with a real photon pulse. In more detail:
The electronic module may comprise at least two banks, e.g., two counters in which one counter counts incoming pulses while the other counter can be read out. The image sensor may further comprise a bank switch unit configured to switch to which of the at least two banks the processed stream is forwarded. The bank switch unit is configured to switch at specific bank switch times. Without further measures, the bank switch time could coincide with a pulse in the processed stream. This means a first part of the pulse is directed to one of the banks whereas a latter part of the pulse is directed to another one of the banks. The two banks thus receive only a partial pulse. If both partial pulses are sufficiently long to be processed as correct pulses, the number of pulses is incorrect, leading to a wrong count number in case of counters. If a partial pulse is rather short, it will not be correctly processed but may cause malfunction of the electronic module. As photons may impinge on the photon-counting detector elements at any time, it cannot be avoided that a bank switch time coincides with the time at which a pulse is generated by a photon hitting one of the photon-counting detector elements.

To counter this problem, an artificial pulse, which may be referred to as a fake photon, is generated which blocks the time of the bank switch, as explained in more detail in the following. The image sensor comprises a pulse generator configured and arranged to introduce artificial pulses (fake photons) to the at least one macropixel stream or one of the pulse shaper output streams. A length of an artificial pulse will be denoted as t_artificial. The monostable/astable circuit processes the artificial pulse such that its pulse length is shortened to the second pulse length t2 followed by a pulse-free interval which will be referred to as an "artificial pulse-free interval". The artificial pulse-free interval has a time span of (at least) t_artificial minus the second pulse length t2. In this way, a pulse-free interval follows each artificial pulse in the processed stream. The pulse generator is configured to introduce the artificial pulses with a timing such that the bank switch times occur during the artificial pulse-free intervals. The artificial pulses thus lead to pulse-free periods during which the bank switches occur.

In general, not all artificial pulses need to have the same length, instead different values for t_artificial may be used.

The pulse generator may be configured to introduce one artificial pulse for every bank switch. A frequency with which artificial pulses are generated may match a frequency of the bank switches. In particular, the pulse generator and the bank switch may operate with a common frequency such that a frequency of the bank switches equals a frequency of the artificial pulses. Each artificial pulse is timed such that its starting time is less than t_artificial before one of the bank switch times, and such that its starting time is more than the second pulse length t2 before one of the bank switch times; this ensures that the bank switch occurs during a pause in which no pulse is present. A time span of t_artificial is larger than t2 and may be, for example, in the range 1.3*t2 < t_artificial < 3.0*t2. This creates a pause with a length between 0.3*t2 and 2.0*t2. In principle, t_artificial may also be longer but this unduly increases the dead time. The before-mentioned range, in contrast, ensures that a bank switch occurs with a sufficient distance to any possible pulses, while keeping the dead time comparatively short.

### General features

The described photon-counting detector elements may form at least one array (sensor array). A pixel shall be understood as one element of the sensor or sensor array, i.e., one photon-counting detector element. Photon-counting detector elements may be, for example, APDs (avalanche photodiodes) or SPAD elements and may output one pulse per registered photon. The photon-counting detector elements may be built in CMOS technology and/or may form one or more arrays, wherein each array may form a silicon photomultiplier (SiPM). The earlier mentioned "signals" from the photon-counting detector elements thus include (electric) pulses when a photon is detected.

The image sensor may in particular be used for applications in which accurate counting of single photons and/or timing information is crucial, e.g., for microscopes, LiDAR systems (LiDAR: light detection and ranging), PET systems (PET: position emission tomography) or particle detectors. Exemplary embodiments thus also comprise a light microscope, a LiDAR, a PET system or a particle detector with an image sensor as described herein.

The time periods t1 and t2 of pulses may be defined as the time periods for which a height of the pulse is above a certain threshold. The threshold may be, for example, 50% of the height of the respective pulse (/ a reference voltage defining a pulse height), or more generally a value between 10% and 100%. Similarly, the time spans referring to pulse-free periods may be defined as the time periods for which a height of the signal is below a certain threshold; this threshold can be identical or different from the threshold used for defining t1 and t2.

The intended use of the described image sensor results in variants of methods of the invention. Similarly, features described with regard to the inventive method shall also form variants the image sensor of the invention.

### BRIEF DESCRIPTION OF THE DRAWINGS

A better understanding of the invention and various other features and advantages of the present invention will become readily apparent by the following description in connection with the schematic drawings, which are shown by way of example only, and not limitation, wherein like reference numerals may refer to alike or substantially alike components:
- FIG. 1: shows schematically components of an image sensor;
- FIG. 2: shows schematically two signals originating from different sensor elements to be combined into one signal;
- FIG. 3: shows schematically signals originating from different sensor elements which are too close to one another to be correctly processed;
- FIG. 4: illustrates schematically required rise and fall times of an electronic module;
- FIG. 5: shows schematically components of an image sensor of the invention and exemplary signals processed by the image sensor;
- FIG. 6: shows schematically pulses processed by a monostable/astable circuit which is a level monostable;
- FIG. 7: shows schematically pulses processed by a monostable/astable circuit which is an edge-delayed monostable;
- FIG. 8: shows schematically strongly overlapping pulses which the edge-delayed monostable interprets as just one pulse;
- FIG. 9: shows schematically a bank switch which forwards signal intervals to different banks;
- FIG. 10: shows schematically how a bank switch splits a pulse;
- FIG. 11: shows schematically components of a further embodiment of an image sensor of the invention;
- FIG. 12: shows schematically signals of the image sensor of FIG. 11;
- FIG. 13: shows schematically further signals of the image sensor of FIG. 11;
- FIG. 14: shows schematically components of a further embodiment of an image sensor of the invention; and
- FIG. 15: shows an exemplary monostable/astable circuit as used in various embodiments of an image sensor of the invention.

### DETAILED DESCRIPTION OF EMBODIMENTS

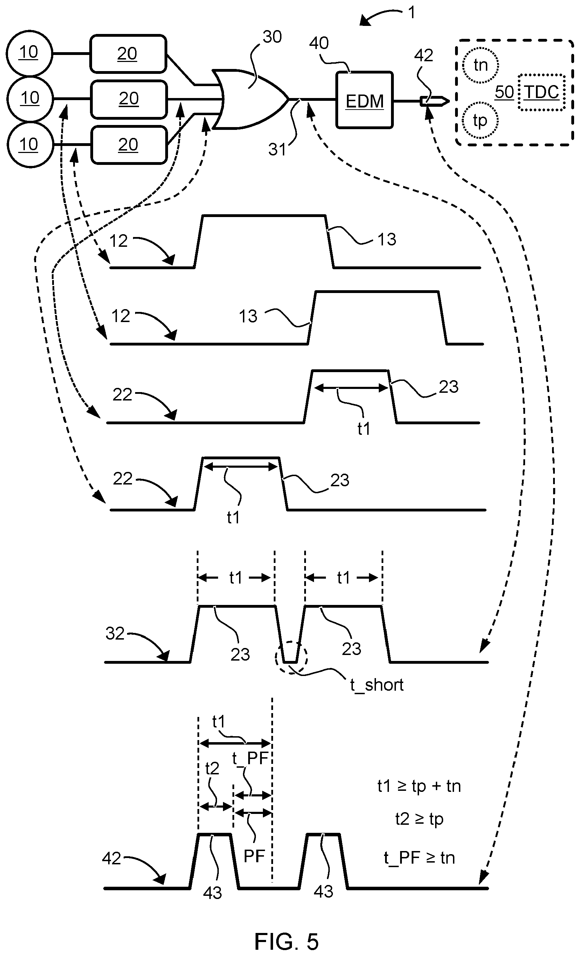

### FIG. 5: Anti-glitch circuit with monostable/astable circuit

FIG. 5 shows schematically an image sensor 1 of an exemplary embodiment of the invention. The image sensor 1 comprises a plurality of photon-counting detector elements 10, such as SPADs, which are configured to output an electric pulse 13 upon registration of a photon. FIG. 5 shows schematically the signals 12 output by two different photon-counting detector elements 10. Each signal 12 includes one pulse 13, indicating detection of a respective photon. For all pulses, the horizontal axis indicates time and the vertical direction indicates an electric signal strength, e.g., voltage or current. The photons causing the two depicted pulses 13 are thus received at different points in time, wherein the two pulses 13 overlap.

The image sensor 1 includes a first group of pulse shapers 20 (e.g., monostables), wherein the output signal 12 of each photon-counting detector element 10 is directed to a respective pulse shaper 20. The pulse shapers 20 are in this example monostables and process the signals 12, wherein the outputs of the pulse shapers 20 will be referred to as pulse shaper output streams 22. The pulse shapers 20 change (here: shorten) the length of the pulses 13, thus converting the pulses 13 to pulses 23 with a specific length t1 which is common to all pulses 23 in the pulse shaper output streams 22. The pulse shapers 20 thus preserve the number and timing (starting time) of the pulses 13, wherein the pulse length is changed.

The image sensor 1 further comprises a combination gate or connection unit 30 which combines the pulse shaper output streams 22 into a macropixel output / macropixel stream 32 which is output via a macropixel output line 31. For easier understanding, the schematic drawing only shows a small number of photon-counting detector elements 10 whose outputs are all combined into one macropixel stream 32. However, the overall image sensor 1 may include a considerably larger number of photon-counting detector elements 10, e.g., between one hundred and ten thousand, each being provided with a respective pulse shaper 20. The connection unit 30 may comprise a plurality of macropixel output lines 31 for outputting several macropixel streams 32, for example, a number between ten and one thousand. The macropixel streams 32 differ in which outputs of photon-counting detector elements 10 they combine. The connection unit 30 may be fixed or flexible. In a flexible design, it is possible to adjust the connection unit 30 to change which of the pulse shaper output streams 22 are combined into one macropixel stream 32. In a fixed design, it is predefined which of the pulse shaper output streams 22 are combined into one macropixel stream 32. The connection unit 30 may use logical OR connections to combine pulse shaper output streams 22, i.e., a high level is output when any one of the received pulse shaper output streams 22 has a high level. The macropixel stream 32 thus includes all pulses 23 of the received pulse shaper output streams 22. The length of the pulses 23 is not changed by the connection unit 30.

As shown in this example and also addressed in the introductory portion with regard to FIGS. 3 and 4, a gap or time span t_short may be too short for correct processing by a subsequent electronic module 50, e.g., a digital counter or a time-to-digital-converter TDC. This is generally the case if t_short is smaller than a recovery time tn of the electronic module 50 which the electronic module 50 needs to recover an original internal state after the end of one pulse. As photons may impinge on photon-counting detector elements 10 at any time, the gap t_short between two pulses 23 may have any value.

The image sensor 1 further comprises a monostable or astable, referred to as a monostable/astable circuit 40, which receives the macropixel stream 32. In the case of several macropixel output lines 31, an equal number of monostable/astable circuits 40 can be provided in parallel to each other. The monostable/astable circuit 40 is configured such that it shortens a pulse length of each pulse 23 of the macropixel stream 32. The monostable/astable circuit 40 thus outputs a signal, referred to as a processed stream 42, in which each pulse 43 has a second pulse length t2 which is shorter than t1. The number of pulses and their starting time is generally preserved by the monostable/astable circuit 40, only the pulse length is shortened from t1 to t2. This has the consequence that a pulse-free interval PF is created after each pulse 43. The time span t_PF of the created pulse-free interval PF may be equal to t1 minus t2. An overall gap between two consecutive pulses 43 may then be equal to t_PF plus the original gap t_short between the pulses 23. The additional pulse-free interval PF reduces the risk that the recovery time tn of an electronic module 50 is violated. In general, t_PF may have any value as also a small additional gap between pulses helps to reduce the risk of errors in an electronic module. For sake of clarity, it is noted that the electronic module 50 can optionally be regarded as part of the image sensor 1 of the invention, and is thus drawn in dashed lines. If the electronic module 50 is part of the image sensor 1, the pulse shapers 20 and/or the monostable/astable circuit 40 may be configured in dependence of the recovery time tn and a minimum pulse length tp required by the electronic module 50.

If t1 and t2 are set such that t1 - t2 ≥ tn, then the recovery time tn of the electronic module is always observed irrespective of the timing of any photons impinging on the photon-counting detector elements 10, i.e., the risk of violating tn is not only reduced but fully eliminated. If t2 is set such that t2 ≥ tp, then the required minimum pulse length will always be met. In this case it follows that t1 is set such that t1 ≥ tp + +tn.

Note that reducing the risk of a violation of tn is only achieved with two consecutive monostables (more generally: a pulse shaper 20 followed by a monostable/astable circuit 40), wherein the latter monostable produces shorter pulses. If the monostable/astable circuit 40 were not used and the pulse shapers 20 produced pulses with a short length of t2, then again any gap t_short between two consecutive pulses would be possible.

The monostable/astable circuit 40 may in principle be any kind of astable or monostable such as a level monostable or an edge-delayed monostable (EDM). However, an EDM has certain advantages described with regard to the following figures.

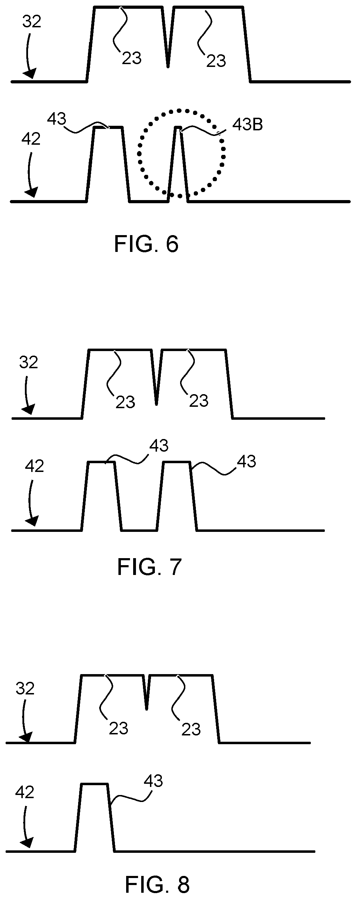

### FIGS. 6 to 8: Outputs of monostable/astable circuits

FIG. 6 shows a macropixel stream 32 supplied to a monostable/astable circuit 40 which is here a level monostable. In this example, two pulses 23 in the macropixel stream 32 are not clearly separated from each other. Level monostables generally output shorter pulses if their recovery time is not met. Therefore, the monostable/astable circuit 40 of this example only processes the first pulse correctly to output a pulse 43 with a desired pulse length, whereas the second pulse leads to a shorter pulse 43B.

FIG. 7 shows the macropixel stream 32 of the previous figure, which is, however, in this case supplied to a monostable which is an EDM. In contrast to level monostables, the pulse width generated by EDMs is unrelated to the input pulse. This plays an important role in the glitch suppression. The EDM does not have a recovery time as it does not depend on the input pulse, and thus input pulses 23 which are not separated or may even overlap will lead to output pulses 43 of the same width as in any other case. As shown, the EDM (monostable/astable circuit 40) outputs a processed stream 42 in which the pulses 43 have the same length/width.

FIG. 8 shows a macropixel stream 32 with two pulses 23 too close to be recognized as two pulses by the EDM. This is the case if the falling edge of the first pulse and the rising edge of the second pulse strongly overlap such that the signal does not drop sufficiently between the two pulses 23. In this case, the EDM interprets the two pulses 23 as one pulse. The EDM rejects the incomplete edge between the pulses 23 and is not triggered; thus, suppressing the second pulse. As an advantage, the EDM does not output any corrupt pulses which may cause errors in subsequent electronics, in contrast to a level monostable, as described with regard to FIG. 6.

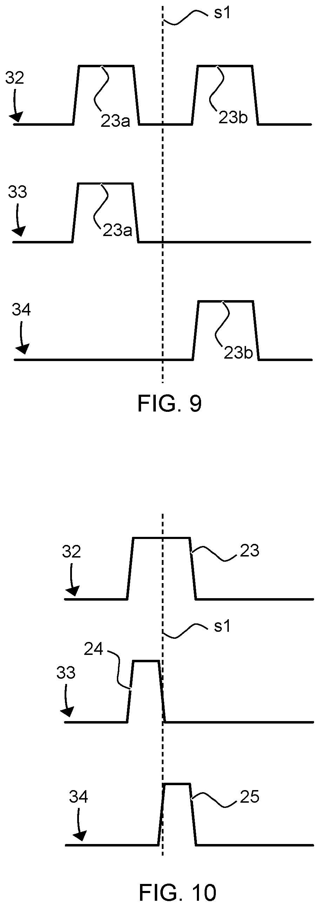

### FIGS. 9 and 10: Bank switch

The electronics that serves the photon-counting detector elements may work in double buffering mode. In this case, there are two electronics banks with the same functionality switching after a predefined time. The reason for this is to achieve a service time near 100%, since one of the two banks is active receiving pulses from the photon-counting detector elements while the other bank is inactive and can be read out by an external system. The output signal goes alternatively to a first bank and a second bank after every switch. FIG. 9 schematically shows the macropixel stream 32 including pulses 23a and 23b. Up to the time of a bank switch s1, the macropixel stream 32 is supplied to a first bank, which thus receives a first part 33 of the macropixel stream 32 which only includes the pulse 23a before the bank switch s1 but not the pulse 23b after the bank switch s1. After the time of the bank switch s1, the macropixel stream 32 is supplied to the second bank, which thus receives a second part 34 of the macropixel stream 32 which only includes the pulse 23b but not the pulse 23a.

However, a pulse may come at any random time and thus also at the exact time a bank switch is occurring. FIG. 10 shows this case in which a pulse 23 in the macropixel stream 32 occurs exactly at the time of the bank switch s1. The pulse 23 is split into two pulse parts 24 and 25, which may have any proportions, depending on the starting time of the pulse 23 relative to the time of the bank switch s1. The first bank receives a first part 33 of the macropixel stream 32 which includes the pulse part 24, whereas the second bank receives a second part 34 of the macropixel stream 32 which includes the pulse part 25.

The pulse parts 23 and/or 24 constitute pulses that may not meet the requirements for tp discussed earlier, i.e., the pulse parts 23 and/or 24 are shorter than a minimum pulse time required by a subsequent electronic module. Especially if the pulse 23 is generated by a monostable with a length that is not unduly long, e.g., a length of tp or slightly above tp, then the pulse parts 23 and 24 will be shorter then tp in most cases. The pulse parts 23 and 24 can thus cause malfunction of an electronic module.

This problem is overcome with a design as explained with regard to the following figure.

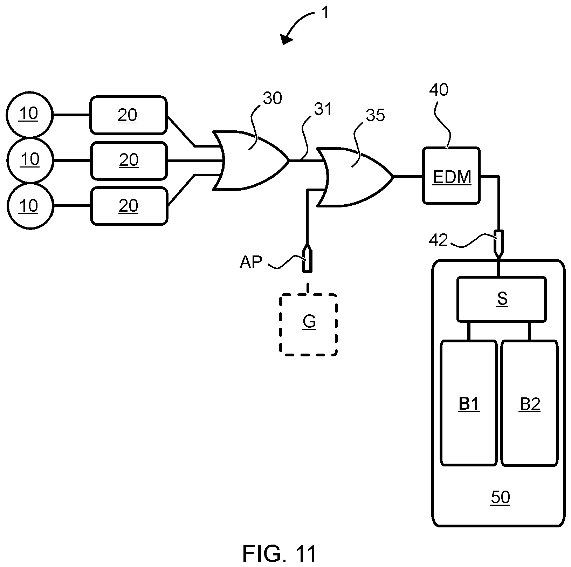

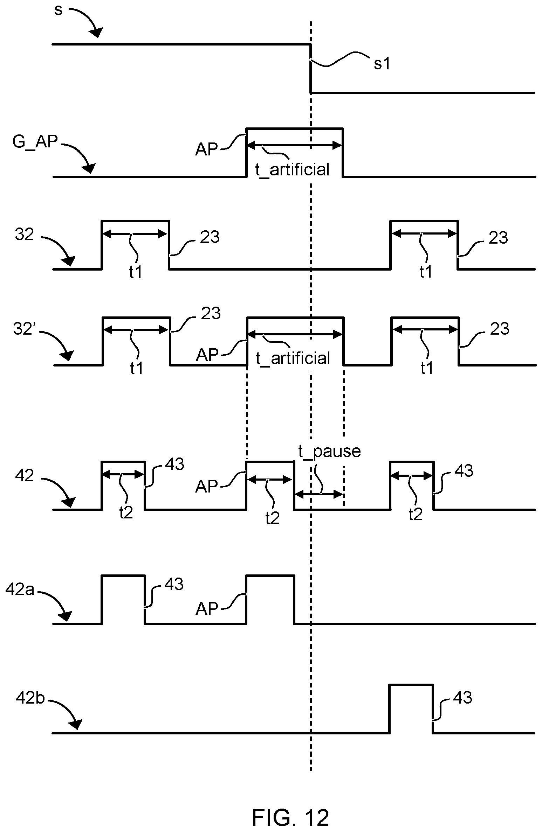

### FIGS. 11 and 12: Bank switch assistant using fake photons

FIG. 11 shows schematically an image sensor 1 of a further exemplary embodiment of the invention. The image sensor 1 comprises a plurality of photon-counting detector elements 10, a first group of pulse shapers 20 (e.g., monostables), a connection unit 30, at least one monostable/astable circuit 40 and an electronic module 50, all of which may be configured as described with regard to FIG. 5.

The electronic module 50 includes two banks B1 and B2, e.g., counter banks used to count pulses / photons. One counter can be read-out while the other counter is active counting incoming pulses. A bank switch S of the electronic module 50 determines to which of the banks B1 and B2 the processed stream 42 is input. Examples of electronic modules 50 are: a ripple counter, a binary counter, an LFSR counter, a gray counter, a pre-scaler, a TDC or any other electronic circuit susceptible to metastability.

In order to overcome the problems caused by a bank switch coinciding with a pulse in the processed stream 42, an artificial pulse (fake photon) AP is generated which causes a pulse-free interval at the time of the bank switch. In more detail: A pulse generator G provides an artificial pulse AP which is added to the macropixel stream of the connection unit 30. This may be accomplished with an OR gate 35 (or another component which combines two inputs into a joint output) at the macropixel output line 31, between the connection unit 30 and the EDM / monostable/astable circuit 40. The monostable/astable circuit 40 shortens the artificial pulse AP and produces a pause (pulse-free interval) after the shortened artificial pulse. Generation of the artificial pulses AP is timed in dependence on the bank switches such that each bank switch occurs during the pulse-free interval which the monostable/astable circuit 40 causes directly after the shortened artificial pulse.

The pulse-free interval for the bank switch is produced by the monostable/astable circuit 40 independent on the arrival time of any pulses caused by real photons, i.e., irrespective of any pulses in the macropixel stream before the artificial pulse AP is added. In case a pulse is included in the macropixel stream which would coincide with a bank switch, this pulse would overlap with the artificial pulse AP, resulting in just one pulse which will then be shortened by the EDM, causing again a pulse-free interval at the time of the bank switch.

The described design thus allows to eliminate any spurious pulses or glitches that may appear when a bank is swapped. It should be noted that when the fake photon pulse is in the line, no real pulse will be accepted by the EDM; as a consequence, there is a loss in sensitivity which is equal to t_artificial / tb, where tb is the time that a bank is active. This ratio can be around 1% for practical cases.

The effects of the artificial pulses AP will be further described with regard to FIG. 12.

FIG. 12 shows graphs of different signals, wherein the horizontal direction indicates time. A bank switch signal s indicates that a bank switch occurs at a time s1. The pulse generator generates an output G_AP which includes a pulse (artificial pulse AP) with a time length of t_artificial. A macropixel stream 32, which is output by the connection unit, includes pulses 23 each having a length of t1 (t1 being set by the first group of pulse shapers). The OR gate adds the pulse generator output G_AP to the macropixel stream 32, creating a "macropixel stream with added artificial pulses" 32' which includes all pulses 23 of the macropixel stream 32 and the artificial pulse(s) AP. The "macropixel stream with added artificial pulses" 32' is supplied to the monostable/astable circuit 40 which shortens all pulses to a length of t2, resulting in the schematically depicted processed stream 42. The processed stream 42 is supplied to the electronic module, where it is split at the bank switch time s1. A first part 42a of the processed stream 42 including only all pulses up to the bank switch time s1 is supplied to the first bank, whereas a second part 42b of the processed stream 42 including only all pulses after to the bank switch time s1 is supplied to the second bank.

The starting time and length of the artificial pulse AP are chosen to ensure that there is no pulse at the bank switch time s1. For this goal, a starting time of the artificial pulse AP is chosen to be earlier than t2 before the bank switch time s1, and the pulse length t_artificial is chosen to be larger than t2. The monostable/astable circuit 40 shortens a length of the artificial pulse AP to t2, and hence a pulse-free interval with a length of t_pause = t_artificial - t2 is created. Due to the shortened length t2 of the artificial pulse AP, the artificial pulse AP in the processed stream 42 ends before the bank switch s1 occurs. The starting time of the artificial pulse AP is chosen to be less than t_artificial before the bank switch time, which has the consequence that the artificial pulse free interval t_pause (after the shortened artificial pulse) is not yet over when the bank switch s1 occurs.

Furthermore, t2 and t1 may be chosen as described with regard to the embodiment of FIG. 5. In particular, t2 may be chosen as t2 ≥ tp, and t1 may be chosen as t1 ≥ tp+tn.

When the bank switch occurs, the artificial pulse AP is shrunk by the EDM in such a way that the artificial pulse AP meets the requirements of the electronics for tp. As the input of the EDM is set up, any other real photon will be rejected during this switching time. In this way, a bank-switch assistant is provided which reliably rules out that any pulses will be split by a bank switch.

The artificial pulse AP can of course be discarded or compensated by the electronic module. For example, in the case of a counter, the count number can be reduced by one for every bank switch that occurs (or every generated artificial pulse), thus compensating for counting the artificial pulse AP.

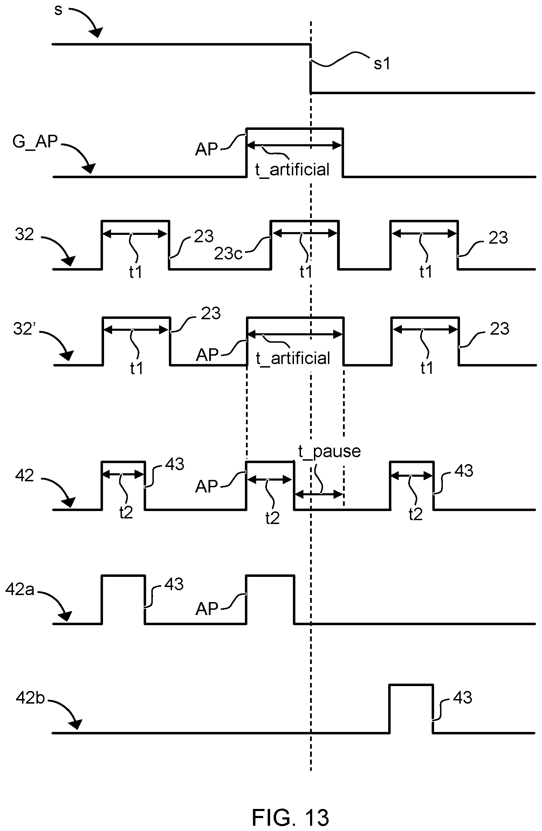

### FIG. 13: Pulse-free period at bank switch times

FIG. 13 illustrates a case in which a bank switch s1 coincides with a pulse 23c in the macropixel stream 32. As also the artificial pulse AP coincides with the banks switch s1, the pulse 23c and the artificial pulse AP will result in just one pulse in the combined output 32'. In the example shown, the artificial pulse AP fully covers the time of the pulse 23c, i.e., it starts before and ends after the pulse 23c, and thus the combined output 32' incudes just one pulse AP with a length of t_artificial, identically to the case described with regard to the preceding figure.

This illustrates that a pulse 23c coinciding with the bank switch s1 will be filtered out. The artificial pulse thus creates a deadtime of t_artificial.

For completeness, if the pulse 23c only overlaps with the artificial pulse AP but is not fully covered by the artificial pulse AP, then these two pulses will still result in just one pulse in the combined output 32' which has, however, a length larger than t_artificial (and at most t_artificial + t1). The monostable/astable circuit 40 will again shorten this pulse such that a pulse-free interval is created during which the bank switch occurs.

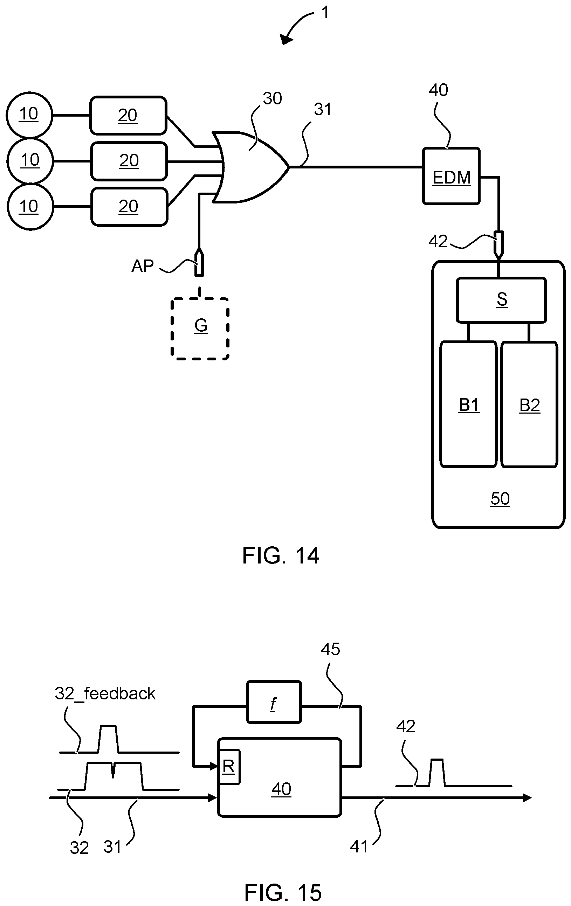

### FIG. 14: Variation in the introduction of fake photons

FIG. 14 is a variation of FIG. 11 and varies from FIG. 11 in that the pulse generator G is not connected to the macropixel output line 31 (i.e., downstream of the connection unit 30); instead the pulse generator G connects to an input of the connection unit 30 and thus supplies an artificial pulse AP to the connection unit 30, which combines the artificial pulse AP with any pulses output by the pulse shapers 20. In both cases of FIGS. 11 and 14, the artificial pulses AP are finally included in the macropixel stream of the macropixel output line 31. The OR gate 35 of FIG. 11 is not needed in the embodiment of FIG. 14. As a further variation of the embodiment shown in FIG. 14, the artificial pulses AP could also be added to the input of one or more of the pulse shapers 20.

### FIG. 15: Monostable/astable circuit with feedback loop

FIG. 15 shows schematically a monostable/astable circuit 40 like an EDM which can be used in the embodiments described with regards to the other figures. A macropixel output line 31 connects to an input of the monostable/astable circuit 40. In this example, a macropixel stream 32 carried by the macropixel output line 31 includes two strongly overlapping pulses. The monostable/astable circuit 40 has at least two exit ports, one of which is connected to a feedback loop 45 that leads back to an entrance of the monostable/astable circuit 40, in this case to a reset entrance R. The feedback loop 45 is provided with a function f, i.e., an electronic component that modifies the signal in the feedback loop at least by varying/shifting its phase, resulting in a feedback signal 32_feedback. In the case of strongly overlapping pulses, as depicted, the latter pulse may not be recognized and hence the feedback signal 32_feedback includes only one pulse for two strongly overlapping pulses in the macropixel stream 32. Otherwise, each pulse of the macropixel stream 32 leads to one pulse in the feedback signal 32_feedback. At an output line 41, the monostable/astable circuit 40 outputs the processed stream 42 generated in dependence of the macropixel stream 32 and the feedback signal 32_feedback. Pulses in the processed stream 42 have a shorter pulse length than pulses in the macropixel stream 32, due to the operation of the monostable/astable circuit 40 and its resetting after a specified delay.

The features described with regard to different figures may be combined. Furthermore, the described embodiments are reduced in complexity for easier understanding. In particular, an image sensor may comprise a plurality of macropixel output lines. The described features refer to just one macropixel output line. Similar structures may be provided for each macropixel output line. In particular, a monostable/astable circuit 40 and the introduction of an artificial pulse AP may be provided for each macropixel output line.

### List of reference signs

- 1: image sensor
- 1': related image sensor
- 10: photon-counting detector elements
- 12: signals from the photon-counting detector elements 10
- 13: pulse from a photon-counting detector element 10
- 20: first group of pulse shapers
- 20': monostables
- 22: pulse shaper output streams
- 23, 23a-23c: pulses output by the first group of pulse shapers 20 / pulses in the pulse shaper output stream 22
- 24, 25: pulse parts created by bank switch splitting a pulse 23
- 30: connection unit for combining pulse shaper output streams 22
- 31: macropixel output line(s)
- 32: macropixel stream / macropixel output
- 32': macropixel stream with added artificial pulse (fake photon)
- 32_feedback: feedback signal of the monostable/astable circuit 40
- 33: first part of the macropixel stream 32, before a bank switch
- 34: second part of the macropixel stream 32, after a bank switch
- 35: OR gate combining the artificial pulse and the macropixel stream
- 40: monostable/astable circuit
- 41: output line of the monostable/astable circuit 40
- 42: processed stream (output by the monostable/astable circuit 40)
- 42a: first part of the processed stream (before a bank switch)
- 42b: second part of the processed stream (after a bank switch)
- 43: pulses (in the processed stream 42)
- 43B: spurious pulse
- 45: feedback loop of monostable/astable circuit 40
- 50: electronic module
- 52: input signal for the electronic module
- AP: artificial pulse
- B1, B2: banks, e.g., counters
- EDM: edge delayed monostable
- f: function (electronic component) in the feedback loop 45
- G: pulse generator which provides artificial pulses AP
- G_AP: output of the pulse generator
- PF: pulse-free interval (after pulses 43 in processed stream 42)
- R: reset entrance of the monostable/astable circuit
- S: bank switch unit
- s: bank switch signal
- s1: bank switch time
- t1: first pulse length (i.e., length of pulses 23)
- t2: second pulse length (i.e., length of pulses 43)
- TDC: time-to-digital-converter
- tn: recovery time of electronic module (i.e., required length of a pause between pulses)
- tp: minimum pulse length required by the electronic module
- t_artificial: pulse length of artificial pulses AP
- t_pause: artificial pulse-free interval
- t_PF: length of pulse-free interval; difference between first and second pulse lengths t1, t2
- t_short: gap between two pulses in the macropixel stream

## Claims

1. An image sensor including:
photon-counting detector elements (10);
a first group of pulse shapers (20) which are arranged to convert signals (12) from the photon-counting detector elements (10) into pulse shaper output streams (22) in which pulses (23) have at minimum a first pulse length (t1);
a connection unit (30) configured to combine a plurality of the pulse shaper output streams (22) into at least one macropixel stream (32);
**characterized by**
at least one monostable/astable circuit (40) arranged to receive the at least one macropixel stream (32) and to output a processed stream (42) in which pulses (43) have a second pulse length (t2),
wherein the at least one monostable/astable circuit (40) is configured such that the second pulse length (t2) is shorter than the first pulse length (t1) by a time span t_PF, to create a pulse-free interval (PF) for at least the time span t_PF after each pulse (43) in the processed stream (42).

2. The image sensor according to claim 1,
wherein the first group of pulse shapers (20) consists of a group of monostables, and wherein the at least one monostable/astable circuit (40) is a further monostable.

3. The image sensor according to claim 1 or 2, further including
an electronic module (50) to process the processed stream (42), wherein the electronic module (50) requires a pause with a length of at least tn between two pulses (43) in the processed stream (42),
wherein the at least one monostable/astable circuit (40) is configured such that t_PF is at least as long as tn.

4. The image sensor according to claim 3,
wherein the electronic module (50) comprises at least one of: a time-to-digital-converter (TDC), a digital counter, a level comparator, a trigger, a scaler, an inverter, a buffer, a pull-up, a latch, a level monostable, a clock divider and a phase detector.

5. The image sensor according to claim 3 or 4,
wherein the first group of pulse shapers (20) and the at least one monostable/astable circuit (40) are configured such that t_PF < 2 * tn, for restricting a deadtime of the image sensor.

6. The image sensor according to any one of claims 3 to 5,
wherein the electronic module (50) requires that pulses (43) in the processed stream (42) have a minimum pulse length of tp;
wherein the at least one monostable/astable circuit (40) is configured such that the second pulse length (t2) is at least as long as tp;
wherein the first group of pulse shapers (20) is configured such that the first pulse length (t1) is at least as long as tp+tn.

7. The image sensor according to claim 6,
wherein the first group of pulse shapers (20) is configured such that the first pulse length (t1) is shorter than 2*[tp+tn] for restricting a deadtime of the image sensor.

8. The image sensor according to any one of claims 1 to 7,
wherein the at least one monostable/astable circuit (40) is not a level monostable but an edge delayed monostable (EDM).

9. The image sensor according to any one of claims 3 to 8,
wherein the electronic module (50) comprises at least two banks (B1, B2);
wherein the image sensor further comprises a bank switch unit (S) configured to switch to which of the at least two banks the processed stream (42) is forwarded, wherein the bank switch unit (S) is configured to switch at specific bank switch times (s1);
wherein the image sensor further comprises a pulse generator (G) configured and arranged to introduce artificial pulses (AP) to the at least one macropixel stream (32) or one of the pulse shaper output streams (22), wherein each artificial pulse (AP) has a length of t_artificial;
wherein the at least one monostable/astable circuit (40) processes each artificial pulse (AP) such that its pulse length is shortened to the second pulse length (t2) followed by an artificial pulse-free interval (t_pause) with a time span of at least t_artificial minus the second pulse length (t2);
wherein the pulse generator (G) is configured to introduce the artificial pulses (AP) with a timing such that the bank switch times (s1) occur during the artificial pulse-free intervals (t_pause).

10. The image sensor according to claim 9,
wherein the pulse generator (G) is configured to introduce one artificial pulse (AP) for every bank switch, and wherein each artificial pulse (AP) is timed such that its starting time is less than t_artificial before one of the bank switch times (s1), and such that its starting time is more than the second pulse length (t2) before one of the bank switch times (s1).

11. The image sensor according to claim 9 or 10,
wherein the pulse generator (G) and the bank switch (S) operate with a common frequency such that a frequency of the bank switch times (s1) equals a frequency of the artificial pulses (AP).

12. A measuring system which is one of: a microscope, a LIDAR system, a position emission tomography system or a particle detector, including the image sensor according to one of claims 1 to 11.

13. A method for operating an image sensor, including:
receiving photons with photon-counting detector elements (10) which output signals (12) indicative of received photons;
using a first group of pulse shapers (20) to convert the signals (12) of the photon-counting detector elements (10) into pulse shaper output streams (22) in which pulses (23) have a first pulse length (t1);
using a connection unit (30) to combine a plurality of the pulse shaper output streams (22) into at least one macropixel stream (32);
**characterized by**
using at least one monostable/astable circuit (40) which processes the at least one macropixel stream (32) to output a processed stream (42) in which pulses (43) have a second pulse length (t2) which is shorter than the first pulse length (t1) by a time span t_PF, thus creating a pulse-free interval (PF) for at least the time span t_PF after each pulse (43) in the processed stream (42).
